# EUROPÄISCHE PATENTSCHRIFT

(11) **EP 2 764 138 B1**
(45) Veröffentlichungstag und Bekanntmachung des Hinweises auf die Patenterteilung: **29.04.2015**
(21) Anmeldenummer: 11832088.6
(22) Anmeldetag: 08.10.2011
(51) Int. Cl.: C25F 7/02

(54) **ÄTZVORRICHTUNG ZUM ELEKTROLYTISCHEN ÄTZEN VON KUPFER**
ETCHING DEVICE FOR THE ELECTROLYTIC ETCHING OF COPPER
DISPOSITIF DE GRAVURE POUR UNE ATTAQUE ÉLECTROLYTIQUE DU CUIVRE

(43) Veröffentlichungstag der Anmeldung: 13.08.2014
(73) Patentinhaber: Herkle, Christoph, 73529 Schwäbisch Gmünd (DE)
(72) Erfinder: Herkle, Christoph, 73529 Schwäbisch Gmünd (DE)
(74) Vertreter: Hofstetter, Schurack & Partner
(86) Internationale Anmeldenummer: PCT/DE2011/001810
(87) Internationale Veröffentlichungsnummer: WO 2013/050008

(56) Entgegenhaltungen:
- EP-A1- 0 122 963
- DE-A1- 4 208 582
- DE-A1- 10 002 000
- FR-A1- 2 762 232

## Beschreibung

Die Erfindung betrifft eine Ätzvorrichtung zum elektrolytischen Ätzen von Kupfer auf einem Ätzgut wie zum Beispiel gedruckten Schaltungen oder Leiterplatten.

Um Kupfer auf einer gedruckten Schaltung oder einer Leiterplatte elektrolytisch zu ätzen, kann eine Kupfer enthaltende Ätzflüssigkeit zum Einsatz kommen. Die Ätzflüssigkeit weist dann zum Beispiel Kupfer(II)-Chlorid auf, welches in Kontakt mit dem Kupfer der Schaltung oder der Leiterplatte zu Kupfer(I)-Chlorid reduziert wird. Dieses Reaktionsprodukt greift das Kupfer kaum noch an und muss wieder zu Kupfer(II)-Chlorid regeneriert werden, wenn die Ätzflüssigkeit erneut zum Einsatz kommen soll. Eine solche Regeneration lässt sich mittels Chlorwasserstoffsäure und Wasserstoffperoxid erreichen, wobei Chlorgas anfällt. Alternativ dazu lässt sich ein Ätzen von Kupfer auch auf der Basis von schwefelsauren Elektrolyten erreichen. Dazu ist in Schwefelsäure ein Kupfer(II)-Sulfat gelöst, welches nach einer Reaktion mit abzuätzendem Kupfer zu Kupfer(I)-Sulfat reduziert wird. Nach Zugabe von Wasserstoffperoxid lässt sich wieder ein Kupfer(II)-Sulfat erzeugen, so dass eine derart regenerierte Ätzflüssigkeit dem Ätzgut erneut zugeführt werden kann.

Es hat sich herausgestellt, dass in der Praxis solche Ätzverfahren schwierig zu handhaben sind, da Kupfer in der sauren Lösung katalytisch auf das Wasserstoffperoxid wirkt und dieses zersetzt, so dass der Verbrauch des Wasserstoffperoxids relativ hoch ist. Ferner tritt eine hohe Wärmeentwicklung auf, so dass eine energieintensive Kühlung erforderlich ist.

Ein anderer Ansatz besteht darin, als Oxidationsmittel für Kupfer(I)-Ionen im Elektrolyten kein Wasserstoffperoxid, sondern Ozongas zu verwenden. Zweiwertiges Kupfer reagiert mit dem abzuätzenden Kupfer in schwefelsaurem Elektrolyten gemäß folgender Gleichung zu Kupfer(I)-Sulfat:

Cu + CuSO₄ → Cu₂SO₄.

Das erzeugte Kupfer(I)-Sulfat oxidiert dann mit Schwefelsäure und Ozongas gemäß folgender Gleichung wieder zu Kupfer(II)-Sulfat:

Cu₂SO₄ + H₂SO₄ + O₃ → 2CuSO₄ + H₂O + O₂

Es entsteht hierbei relativ wenig Reaktionswärme, so dass der Aufwand für eine Kühlung erheblich geringer ist. Ferner entsteht kein Chlorgas, sondern Sauerstoff, welcher in einer Ätzvorrichtung mit geringeren Gefahren verbunden ist.

Ätzvorrichtungen nach diesem Verfahren sind bekannt. Mit zunehmenden Anforderungen an die Miniaturisierung der Leiterbahnen auf gedruckten Schaltungen oder Leiterplatten hat sich jedoch gezeigt, dass es schwierig ist, durch Ätzen kontinuierlich während einer längeren Prozesszeit schmale und scharf begrenzte Zwischenräume zwischen Leiterbahnen zu erzielen.

Es ist daher eine Aufgabe der Erfindung, eine Ätzvorrichtung zu schaffen, mit welcher sich mit wenig Ätzfluid kontinuierlich eine große Menge an Kupfer ätzen lässt, wobei auch feine und scharfe Konturen von Leiterbahnen mit hoher Flankensteilheit erreichbar sind.

Die Aufgabe wird durch den Gegenstand des unabhängigen Anspruchs 1 gelöst. Vorteilhafte Weiterbildungen der Erfindung sind Gegenstand der Unteransprüche.

Die erfindungsgemäße Ätzvorrichtung zum elektrolytischen Ätzen von Kupfer auf einem Ätzgut weist auf:
- eine erste Mischvorrichtung, welche eingerichtet ist, einen Kupferionen enthaltenden sauren Elektrolyten und ein Sauerstoffgas oder Ozongas aufzunehmen, um ein erstes Flüssigkeits-Gasgemisch zu bilden, welches aus einem ersten Auslass der ersten Mischvorrichtung in eine daran gekoppelte Verbindungsleitung geleitet werden kann,
- einen Behälter, welcher eine Behälterflüssigkeit enthält,
- eine zweite Mischvorrichtung, welche in dem Behälter angeordnet und von der Behälterflüssigkeit umgeben ist, wobei die zweite Mischvorrichtung eine Saugöffnung aufweist, um die im Bereich der Saugöffnung vorhandene Behälterflüssigkeit anzusaugen, wobei die zweite Mischvorrichtung mit der Verbindungsleitung verbunden und eingerichtet ist, das erste Flüssigkeits-Gasgemisch und die angesaugte Behälterflüssigkeit in eine Verengungszone der zweiten Mischvorrichtung zu leiten, so dass sich die angesaugte Behälterflüssigkeit mit dem ersten Flüssigkeits-Gasgemisch vermischen und somit ein zweites Flüssigkeits-Gasgemisch bilden kann, wobei die zweite Mischvorrichtung einen zweiten Auslass aufweist, aus dem das zweite Flüssigkeits-Gasgemisch ausströmen und sich mit der im Bereich des zweiten Auslasses vorhandenen Behälterflüssigkeit vermischen kann, und
- eine Behälterausgangsleitung, welche eingerichtet ist, die dort vorhandene Behälterflüssigkeit dem in einem Ätzmodul vorgesehenen Ätzgut zuzuführen.

Der Erfinder hat erkannt, dass es nicht genügt, einfach einen Kupfer(I)-Ionen und Kupfer(II)-Ionen enthaltenden sauren Elektrolyten mit Sauerstoffgas, einem Ozongas oder einem Sauerstoff-Ozon-Gasgemisch zu vermischen. Es erfolgt zwar theoretisch eine Oxidation von Kupfer(I)-Ionen zu Kupfer(II)-Ionen, jedoch nimmt bei den bisherigen Ätzvorrichtungen mit zunehmender Zirkulation des Elektrolyten die Menge an zweiwertigem Kupfer ab. Daraufhin nimmt die Ätzwirkung des Elektrolyten immer stärker ab, bis die Ergebnisse der Ätzungen nicht mehr zufrieden stellend sind. Hier setzt die Erfindung an: Bei der erfindungsgemäßen Ätzvorrichtung kommt es zu einer sehr intensiven Durchmischung des zugeführten Sauerstoffgases oder Ozongases mit dem sauren Elektrolyten, so dass eine hohe Konzentration an Mikrogasblasen aus Sauerstoffgas oder Ozongas gebildet werden. Dies führt dazu, dass im Elektrolyten eine große Menge an Kupfer(I)-Ionen wieder zu Kupfer(II)-Ionen oxidiert werden kann, wobei dies nach bereits einem einzigen Durchlauf durch die Ätzvorrichtung erreicht wird. Damit ist es zum einen möglich, einen hohen Wirkungsgrad bei der Regeneration des Elektrolyten zu erreichen. Zum anderen ist mit einer solchen Ätzvorrichtung mit einer kontinuierlich hohen Konzentration an Kupfer(II)-Ionen ein schnelles und scharf konturiertes Ätzen auch in sehr schmalen Vertiefungen zwischen Kupfer-Leiterbahnen erreichbar.

Die Durchmischung des Gases mit dem Elektrolyten wird zum einen mittels einer ersten Mischvorrichtung erreicht, welche eingerichtet ist, einen Kupferionen enthaltenden sauren Elektrolyten und ein Sauerstoffgas oder Ozongas aufzunehmen, um ein erstes Flüssigkeits-Gasgemisch zu bilden. Somit kommt es zu einem ersten Kontakt zwischen Kupfer(I)-Ionen mit Sauerstoff oder Ozongas, so dass bereits ein Teil der Kupfer(I)-Ionen oxidiert werden kann.

Um eine genügende Menge von einwertigem Kupfer zu oxidieren, wird mittels der erfindungsgemäßen Ätzvorrichtung die erste Mischvorrichtung durch eine Verbindungsleitung mit einer zweiten Mischvorrichtung gekoppelt, welcher das erste Flüssigkeits-Gasgemisch zugeführt wird. Die zweite Mischvorrichtung ist in einem Behälter angeordnet und von einer in diesem Behälter enthaltenen Flüssigkeit umgeben. Die zweite Mischvorrichtung weist eine Saugöffnung auf, um die im Bereich der Saugöffnung vorhandene Behälterflüssigkeit anzusaugen. Die zweite Mischvorrichtung ist gemäß der Erfindung derart eingerichtet, dass das erste Flüssigkeits-Gasgemisch und die angesaugte Behälterflüssigkeit in eine Verengungszone geleitet werden, so dass die angesaugte Behälterflüssigkeit mit dem ersten Flüssigkeits-Gasgemisch in intensiven Kontakt kommt und sich beide miteinander vermischen, so dass ein zweites Flüssigkeits-Gasgemisch entsteht.

Das zweite Flüssigkeits-Gasgemisch verlässt die zweite Mischvorrichtung an einem daran vorgesehenen Auslass, wobei das zweite Flüssigkeits-Gasgemisch nach Passieren der Verengungszone entspannt wird und gemäß der Bernoulli-Gleichung mit hoher Geschwindigkeit austritt. Dabei reißt es einen Teil der im Bereich des Auslasses vorhandenen Behälterflüssigkeit mit, so dass es zu einem Vermischen zwischen dem zweiten Flüssigkeits-Gasgemisch und der dort vorhandenen Behälterflüssigkeit kommt. Die Behälterflüssigkeit ist ein Kupferionen aufweisender saurer Elektrolyt. Durch die Verengungszone in der zweiten Mischvorrichtung und das Entspannen im Bereich des Auslasses der zweiten Mischvorrichtung kommt es erneut zu einer starken Vermischung zwischen Elektrolyt und Gas, so dass sich eine große Zahl von Mikrogasblasen bilden können. Durch die Mikrogasblasen wird erreicht, dass eine große Menge von Kupfer(I)-Ionen mit dem sauren Elektrolyten zu Kupfer(II)-Ionen oxidieren.

Das auf diese Weise entstandene und mit Kupfer(II)-Ionen angereicherte Flüssigkeits-Gasgemisch kann dann an einer Behälterausgangsleitung abgegriffen und dem zu ätzenden Gut zugeführt werden.

Vorzugsweise ist die erste Mischvorrichtung eine Venturi-Düse und besonders bevorzugt ein Flüssigkeitsstrahl-Gaskompressor. Bei einer solchen Düse oder einem solchen Kompressor kann der Elektrolyt als Treibstrom und das Sauerstoffgas oder Ozongas als Saugstrom zugeführt werden. Dabei erfolgt ein intensives Vermischen ohne bewegte Teile, so dass eine wartungsarme Mischvorrichtung möglich ist. Eine Venturi-Düse oder ein Flüssigkeitsstrahl-Gaskompressor ist zudem als Zukaufteil relativ kostengünstig.

Gemäß einer Ausführungsform der Erfindung ist die zweite Mischvorrichtung in der unteren Hälfte des Behälters angeordnet und die Behälterausgangsleitung oberhalb der zweiten Mischvorrichtung angeordnet. Damit wird erreicht, dass das Gemisch aus zweitem Flüssigkeits-Gasgemisch mit der am Auslass der zweiten Mischvorrichtung vorhandenen Behälterflüssigkeit erneut von der Saugöffnung der zweiten Mischvorrichtung angesaugt werden kann und in der zweiten Mischvorrichtung nochmals vermischt wird. Bei mehrfachem Wiederholen dieses Vorganges erfolgt ein sehr intensives und langes Vermischen der Fluide, so dass immer mehr Mikrogasblasen aus Sauerstoffgas oder Ozongas entstehen. Nur ein relativ geringer Teil des Gemisches gelangt dann schließlich zu der Behälterausgangsleitung, die das Gemisch auf ein zu ätzendes Gut leiten kann.

Vorzugsweise besteht zwischen der Behälterausgangsleitung und der zweiten Mischvorrichtung ein Abstand von mindestens einem Meter. Damit lässt sich ein mehrfaches Zirkulieren der Behälterflüssigkeit durch die zweite Mischvorrichtung zuverlässig erreichen. Besonders bevorzugt weist der Behälter eine Höhe von mindestens 1,5 Metern bei einem Volumen von mindestens 400 Litern Behälterflüssigkeit auf. Dies führt dazu, dass die Behälterflüssigkeit mehrfach durch die zweite Mischvorrichtung strömt und mindestens zwei Minuten lang in dem Behälter zirkuliert, so dass eine große Zahl von Mikrogasblasen erzeugt wird.

Gemäß einer weiteren Ausführungsform ist die erste Mischvorrichtung geeignet, mindestens 100 Liter pro Minute sauren Elektrolyten und mindestens 50 Liter pro Minute Sauerstoffgas oder Ozongas aufzunehmen. Damit kann bei den üblichen Größen einer Leiterplatte und eines Ätzmoduls eine ausreichende Menge an dort gebildeten Kupfer(I)-Ionen in einem einzigen Zyklus wieder zu Kupfer(II)-Ionen oxidiert werden.

Weitere Vorteile und Merkmale der Erfindung werden mit Bezug auf die nachfolgenden Zeichnungen erklärt, in welchen zeigen:
- Figur 1: eine schematische Darstellung einer Ausführungsform der erfindungsgemäßen Ätzvorrichtung; und
- Figur 2: eine schematische Darstellung der Strömungsverhältnisse in einem Behälter der Ätzvorrichtung gemäß Figur 1.

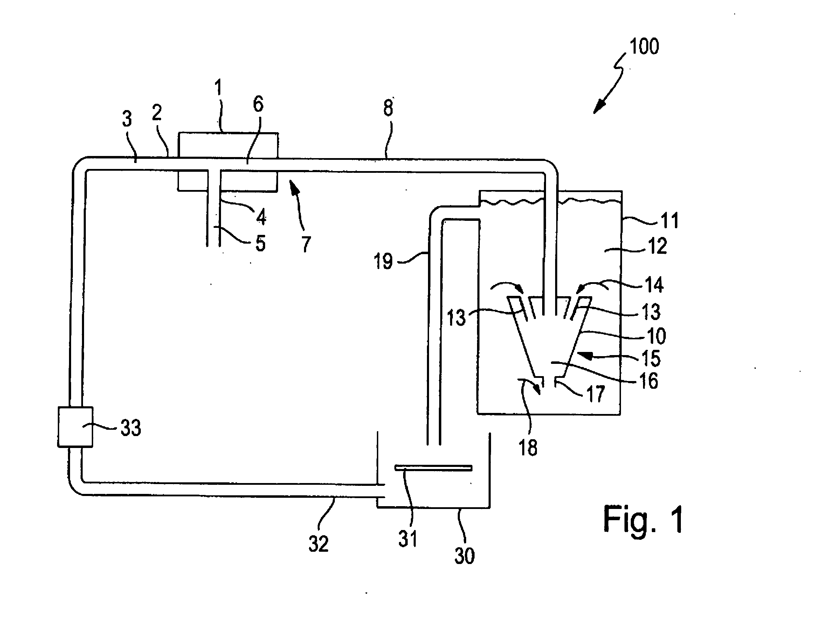

Figur 1 zeigt stark vereinfacht und in schematischer Darstellung eine Ätzvorrichtung 100 gemäß einer bevorzugten Ausführungsform der Erfindung. Die Ätzvorrichtung 100 weist eine erste Mischvorrichtung 1 auf, welche eine erste Zuleitung 2 zur Aufnahme eines sauren Kupferionen enthaltenden Elektrolyten 3 besitzt. Mittels einer zweiten Zuleitung 4 kann ein Gas 5 als Sauerstoffgas, Ozongas oder Sauerstoff-Ozon-Gasgemisch in die erste Mischvorrichtung 1 so eingeleitet werden, dass eine Vermischung mit dem Elektrolyten 3 erfolgt. Das Ergebnis dieses Mischvorganges ist ein erstes Flüssigkeits-Gasgemisch 6, welches die erste Mischvorrichtung 1 an einem ersten Auslass 7 verlassen kann.

Das erste Flüssigkeits-Gasgemisch 6 wird daraufhin über eine Verbindungsleitung 8 zu einer zweiten Mischvorrichtung 10 geleitet, welche in einem Behälter 11 angeordnet ist. Der Behälter ist mit einer Behälterflüssigkeit 12 gefüllt, welche ein saurer Kupferionen aufweisender Elektrolyt ist. Die zweite Mischvorrichtung 10 weist mindestens eine Saugöffnung 13 auf. Durch diese Saugöffnung 13 kann eine im Bereich der Saugöffnung vorhandene Behälterflüssigkeit 14 angesaugt werden. In der zweiten Mischvorrichtung 10 ist eine Zone 15 vorgesehen, in der eine Verengung des Strömungsquerschnitts erfolgt und dadurch das erste Flüssigkeits-Gasgemisch 6 und die Behälterflüssigkeit 14 gut vermischt werden, so dass sich ein zweites Flüssigkeits-Gasgemisch 16 bildet. An einem zweiten Auslass 17 der zweiten Mischvorrichtung 10 tritt dann das zweite Flüssigkeits-Gasgemisch 16 mit hoher Geschwindigkeit aus. Dabei reißt es eine im Bereich des zweiten Auslasses 17 vorhandene Behälterflüssigkeit 18 mit und vermischt sich mit dieser Flüssigkeit.

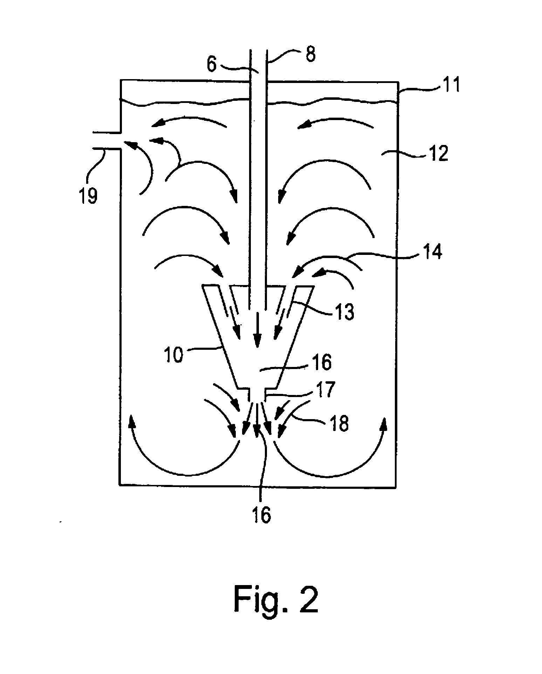

In Figur 2 ist in vereinfachter und stark schematischer Darstellung ein derartiges Vermischen zwischen dem zweiten Flüssigkeits-Gasgemisch 16 und der um den zweiten Auslass 17 vorhandenen Behälterflüssigkeit 18 gezeigt. Die Strömungspfeile deuten an, dass ein Großteil der Behälterflüssigkeit mehrere Male zur Ansaugöffnung 13 der zweiten Mischvorrichtung 10 strömt, um sich dort mit dem aus der Verbindungsleitung 8 ausströmenden ersten Flüssigkeits-Gasgemisch 6 zu vermischen. Dies führt zu einer großen Menge an in der Behälterflüssigkeit 12 verteilten Mikrogasblasen. Nur ein relativ geringer Teil der auf diese Weise intensiv vermischten und mit Mikrogasblasen versehenen Behälterflüssigkeit 12 strömt am Rand des Behälters nach oben zu einer Behälterausgangsleitung 19, welche oberhalb der zweiten Mischvorrichtung 10 angeordnet ist.

Wie aus Figur 1 ersichtlich ist, leitet dann die Behälterausgangsleitung 19 das Flüssigkeits-Gasgemisch zu einem Ätzmodul 30, wo ein Ätzgut wie eine Leiterplatte 31 geätzt werden kann. Dabei entsteht eine Reduktion von Kupfer(II)-Ionen zu Kupfer(1)-Ionen. Die in dem Ätzmodul 30 enthaltene Flüssigkeit mit Kupfer(I)-Ionen und Kupfer(II)-Ionen gelangt dann in eine Rückleitung 32, in der die Flüssigkeit von einer Pumpe 33 unterstützt wieder der ersten Mischvorrichtung 1 zugeführt wird, so dass der Mischvorgang und die Regeneration der Ätzflüssigkeit wieder beginnen kann.

### Bezugszeichenliste:

- 1: erste Mischvorrichtung
- 2: Erste Zuleitung
- 3: Elektrolyt
- 4: Zweite Zuleitung
- 5: Sauerstoffgas oder Ozongas
- 6: erstes Flüssigkeits-Gasgemisch
- 7: erster Auslass
- 8: Verbindungsleitung

- 10: zweite Mischvorrichtung
- 11: Behälter
- 12: Behälterflüssigkeit
- 13: Saugöffnung
- 14: Behälterflüssigkeit im Bereich der Saugöffnung
- 15: Verengungszone
- 16: zweites Flüssigkeits-Gasgemisch
- 17: zweiter Auslass
- 18: Behälterflüssigkeit im Bereich des Auslasses
- 19: Behälterausgangsleitung

- 30: Ätzmodul
- 31: Leiterplatte
- 32: Rückleitung
- 33: Pumpe

- 100: Ätzvorrichtung

## Patentansprüche

1. Ätzvorrichtung zum elektrolytischen Ätzen von Kupfer auf einem Ätzgut, aufweisend:
- eine erste Mischvorrichtung, welche eingerichtet ist, einen Kupferionen enthaltenden sauren Elektrolyten und ein Sauerstoffgas oder Ozongas aufzunehmen, um ein erstes Flüssigkeits-Gasgemisch zu bilden, welches aus einem ersten Auslass der ersten Mischvorrichtung in eine daran gekoppelte Verbindungsleitung geleitet werden kann,
- einen Behälter, welcher eine Behälterflüssigkeit enthält,
- eine zweite Mischvorrichtung, welche in dem Behälter angeordnet und von der Behälterflüssigkeit umgeben ist, wobei die zweite Mischvorrichtung eine Saugöffnung aufweist, um die im Bereich der Saugöffnung vorhandene Behälterflüssigkeit anzusaugen, wobei die zweite Mischvorrichtung mit der Verbindungsleitung verbunden und eingerichtet ist, das erste Flüssigkeits-Gasgemisch und die angesaugte Behälterflüssigkeit in eine Verengungszone der zweiten Mischvorrichtung zu leiten, so dass sich die angesaugte Behälterflüssigkeit mit dem ersten Flüssigkeits-Gasgemisch vermischen und somit ein zweites Flüssigkeits-Gasgemisch bilden kann, wobei die zweite Mischvorrichtung einen zweiten Auslass aufweist, aus dem das zweite Flüssigkeits-Gasgemisch ausströmen und sich mit der im Bereich des zweiten Auslasses vorhandenen Behälterflüssigkeit vermischen kann, und
- eine Behälterausgangsleitung, welche eingerichtet ist, die dort vorhandene Behälterflüssigkeit dem in einem Ätzmodul vorgesehenen Ätzgut zuzuführen.

2. Ätzvorrichtung nach Anspruch 1, wobei die erste Mischvorrichtung eine Venturi-Düse oder ein Flüssigkeitsstrahl-Gaskompressor ist.

3. Ätzvorrichtung nach einem der Ansprüche 1 oder 2, wobei die zweite Mischvorrichtung in der unteren Hälfte des Behälters angeordnet ist und die Behälterausgangsleitung oberhalb der zweiten Mischvorrichtung angeordnet ist.

4. Ätzvorrichtung nach einem der vorherigen Ansprüche, wobei zwischen der Behälterausgangsleitung und der zweiten Mischvorrichtung ein Abstand von mindestens einem Meter besteht.

5. Ätzvorrichtung nach einem der vorherigen Ansprüche, wobei der Behälter eine Höhe von mindestens 1,5 Metern bei einem Volumen von mindestens 400 Litern Behälterflüssigkeit aufweist.

6. Ätzvorrichtung nach einem der vorherigen Ansprüche, wobei die erste Mischvorrichtung geeignet ist, mindestens 100 Liter pro Minute sauren Elektrolyt und mindestens 50 Liter pro Minute Sauerstoffgas oder Ozongas aufzunehmen.

## Claims

1. An etching device for electrolytic etching of copper on an etching material, comprising:
- a first mixing device set up to receive an acidic electrolyte containing copper ions and an oxygen gas or ozone gas, in order to form a first liquid/gas mixture which can be passed out of a first outlet of the first mixing device into a connecting line coupled thereto,
- a vessel containing a vessel liquid,
- a second mixing device arranged within the vessel and surrounded by the vessel liquid, the second mixing device having a suction orifice in order to suck in the vessel liquid present in the region of the suction orifice, and the second mixing device being connected to the connecting line and set up to pass the first liquid/gas mixture and the vessel liquid sucked in into a constriction zone of the second mixing device, such that the vessel liquid sucked in can mix with the first liquid/gas mixture and thus form a second liquid/gas mixture, and the second mixing device having a second outlet through which the second liquid/gas mixture can flow out and mix with the vessel liquid present in the region of the second outlet, and
- a vessel outlet line set up to supply the vessel liquid present therein to the etching material provided in an etching module.

2. The etching device as claimed in claim 1, wherein the first mixing device is a Venturi nozzle or a liquid jet gas compressor.

3. The etching device as claimed in either of claims 1 and 2, wherein the second mixing device is arranged in the lower half of the vessel and the vessel outlet line is arranged above the second mixing device.

4. The etching device as claimed in any of the preceding claims, wherein there is a distance of at least one meter between the vessel outlet line and the second mixing device.

5. The etching device as claimed in any of the preceding claims, wherein the vessel has a height of at least 1.5 meters with a volume of at least 400 liters of vessel liquid.

6. The etching device as claimed in any of the preceding claims, wherein the first mixing device is capable of accommodating at least 100 liters per minute of acidic electrolyte and at least 50 liters per minute of oxygen gas or ozone gas.

## Revendications

1. Appareil de gravure destiné à la gravure électrolytique du cuivre sur un matériau à graver, présentant :
- un premier appareil de mélange, qui est disposé pour recevoir un électrolyte acide contenant des ions de cuivre et un gaz d'oxygène ou un gaz d'ozone, pour former un premier mélange liquide - gaz, lequel peut être dirigé, à partir d'une première évacuation du premier appareil de mélange, dans une conduite de raccordement qui y est couplée,
- un récipient, qui contient un liquide,
- un second appareil de mélange, qui est agencé dans le contenant et est entouré par le liquide contenu dans le contenant, moyennant quoi le second appareil de mélange présente une ouverture d'aspiration, pour aspirer le liquide contenu dans le contenant, présent dans le secteur de l'ouverture d'aspiration, moyennant quoi le second appareil de mélange est relié à la conduite de raccordement et disposé pour diriger le premier mélange liquide - gaz et le liquide, contenu dans le contenant, aspiré, dans une zone de rétrécissement du second appareil de mélange, de sorte que le liquide, contenu dans le contenant, aspiré, peut se mélanger avec le premier mélange liquide - gaz et former ainsi un second mélange liquide - gaz, moyennant quoi le second appareil de mélange présente une seconde évacuation, de laquelle le second mélange liquide - gaz peut s'écouler et se mélanger avec le liquide, contenu dans le contenant, présent dans la seconde évacuation et
- une conduite de sortie du contenant, qui est disposée pour amener le liquide, contenu dans le contenant, qui y est présent, au matériau à graver prévu dans un module de gravure.

2. Appareil de gravure selon la revendication 1, moyennant quoi le premier appareil de mélange est un tube de Venturi ou un compresseur à gaz à jet de liquide.

3. Appareil de gravure selon l'une des revendications 1 ou 2, moyennant quoi le second appareil de mélange est agencé dans la moitié inférieure du contenant et la conduite de sortie du contenant au-dessus du second appareil de mélange.

4. Appareil de gravure selon l'une des revendications précédentes, moyennant quoi un intervalle d'au moins un mètre existe entre la conduite de sortie du contenant et le second appareil de mélange.

5. Appareil de gravure selon l'une des revendications précédentes, moyennant quoi le contenant présente une hauteur d'au moins 1,5 mètre pour un volume d'au moins 400 litres de liquide, contenu dans le contenant.

6. Appareil de gravure selon l'une des revendications précédentes, moyennant quoi le premier appareil de mélange convient pour recevoir au moins 100 litres par minute d'électrolyte acide et au moins 50 litres par minute de gaz d'oxygène ou de gaz d'ozone.
